# EUROPEAN PATENT APPLICATION

(11) **EP 1 786 045 A2**
(43) Date of publication of application: **16.05.2007**
(21) Application number: 06255731.9
(22) Date of filing: 07.11.2006
(51) Int. Cl.: H01L 33/00

(54) **LED package**

(30) Priority: 15.11.2005 KR 20050108909
(71) Applicant: Samsung Electro-Mechanics Co., Ltd., Suwon, Kyungki-do (KR)
(72) Inventor: Lee, Seon Goo, Goonpo Kyungki-do (KR); Choi, Myoung Soo, Kangnam-ku Seoul (KR); Song, Chang Ho, Sungdong-ku Seoul (KR); Park, Young Sam, Songpa-ku Seoul (KR)
(74) Representative: Powell, Timothy John

(57) **Abstract**

An LED package (100) is provided. A light emitting chip (110) generates light when current is applied. A frame (121,122) is electrically connected to the light emitting chip via a wire (115), and has the light emitting chip mounted thereon. A molding (130) fixes the frame thereto, and has a cavity (137) surrounding the light emitting chip and an embossed protrusion (135) formed on a top surface thereof. A lens (140) is domed upward from the embossed protrusion along an outer periphery of the embossed protrusion. The lens is made of a light transmissible resin filled in the cavity. The invention ensures a sufficient view angle of light generated from the LED chip, thereby increasing light extraction efficiency. This consequently simplifies an assembly process, allowing mass production and reducing manufacturing costs.

## Description

### CLAIM OF PRIORITY

This application claims the benefit of Korean Patent Application No. 2005-108909 filed on November 15, 2005 in the Korean Intellectual Property Office, the disclosure of which is incorporated herein by reference.

### BACKGROUND OF THE INVENTION

### Field of the Invention

The present invention relates to a light emitting diode package, more particularly, which ensures a sufficient view angle of light generated from a light emitting chip to improve light extraction efficiency and simplify an assembly process, thereby achieving mass production and reducing manufacturing costs.

### Description of the Related Art

In general, a light emitting diode (LED) package is a semiconductor device which emits light when current is applied, by converting an electrical energy into a light energy via a PN junction diode made of a GaAs or GaN optical semiconductor.

Such an LED emits various lights ranging from red light in the wavelength of 630nm to 700nm to blue-violet light in the wavelength of 400nm, which include blue, green and white lights. The LED is superior to a conventional light source such as incandescent light and fluorescent light in terms of low power consumption, high efficiency and long operation time, thus increasing its demand robustly.

Recently, the LED has seen its application growing from small-scale lighting for a mobile terminal to indoor and outdoor lighting, automobile lighting, backlight for large-scale Liquid Crystal Displays (LCDs).

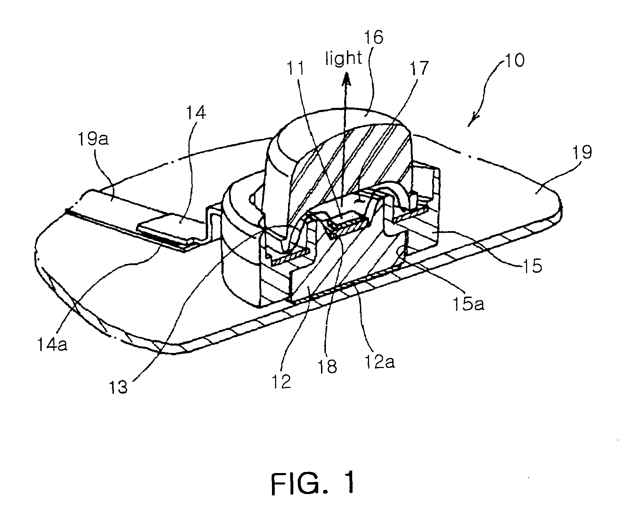

FIG. 1 is a perspective view illustrating the longitudinal section of a central body of a conventional LED package. The conventional LED package 10, as shown, includes a semiconductor light emitting chip 11 and a heat releasing body 12 for mounting the light emitting chip 11 on a central top surface thereof.

The light emitting chip 11 is connected to an external power and electrically connected to a lead frame 14 by metal wires 13 so that current is applied.

The heat releasing body 12 releases heat generated from the light emitting chip 11 outward and cools it. The heat releasing body 12 is bonded onto a substrate 19 by an adhesive 12a made of a high heat conductive material

The lead frame 14 is integrally formed with a molding 15. Here the molding 15 has an assembly hole 15a perforated in a central portion thereof so as to insert and assemble the heat releasing body 12 thereinto. The lead frame 14 has one end provided to the molding 15 to be wire bonded to the wires 13. Also, the lead frame 14 has the other end electrically connected to a circuit pattern 19a printed on the substrate 19 by a pad 14a.

The molding 15 has a lens 16 disposed on a top surface thereof by a mechanical or chemical method. Here the lens 16 is independently made of a transparent material for emitting light generated from the light emitting chip 11 outward in a wider view angle.

The lens 16 is chiefly made of low-priced polymer that is easily injected and thus variously configured. But recently silicone and glass are utilized as the material for the lens 16 to prevent degradation of properties.

Further, a filler 17 made of a transparent silicone resin is filled between the molding 15 and the lens 16 to protect the light emitting chip 11 and wires 13 and also project the emitted light therethrough.

However, it is a complicated process to dispose the separately manufactured lens 16 on the molding 15 and fill the filler 17 between the lens 16 and molding 15. This accordingly undermines work productivity. In addition, when the lens 16 is mounted, the filler 17 is leaked outside or bubbles are trapped inside the filler 17, thereby lowering optical efficiency.

Moreover, the lens 16, made of polymer, experiences degradation due to high energy light generated from the light emitting chip 11, thereby shortening useful life of the product. On the other hand, the lens 16, made of silicone, is expensive in manufacturing costs. Also, the lens 16, made of glass, is easily breakable by handling or during an assembly process.

### SUMMARY OF THE INVENTION

The present invention has been made to solve the foregoing problems of the prior art and it is therefore an object according to certain embodiments of the present invention is to provide a light emitting diode package which ensures a sufficient view angle of light generated from a light emitting chip to improve light extraction efficiency and a simplified assembly process to achieve mass production and save manufacturing costs.

According to an aspect of the invention for realizing the object, there is provided a light emitting diode package including a light emitting chip for generating light when current is applied; a frame electrically connected to the light emitting chip via a wire, and having the light emitting chip mounted thereon; a molding fixing the frame thereto, and having a cavity surrounding the light emitting chip and an embossed protrusion formed on a top surface thereof; and a lens domed upward from the embossed protrusion along an outer periphery of the embossed protrusion, the lens comprising a light transmissible resin filled in the cavity.

Preferably, the embossed protrusion is shaped as a circular ring, which has an inner surface extending from an inner surface of the cavity and an outer surface extending perpendicular to a top surface of the molding.

More preferably, the light emitting diode disposed in the cavity is aligned with the center of an inner diameter of the embossed protrusion.

Preferably, the light emitting diode package further comprises a reflecting member for reflecting light generated from the light emitting chip disposed on an inner surface of the cavity. Preferably, the lens further comprises a light scattering agent contained in the light transmissible resin.

More preferably, the light scattering agent comprises at least one of epoxy and silicone.

More preferably, the light scattering agent comprises one selected from a group consisting of barium titanate, titanium oxide, aluminum oxide and silicone oxide.

Preferably, a height of the lens is adjusted by viscosity that affects flow of a resin and a thixotropic index that affects shape of the resin.

### BRIEF DESCRIPTION OF THE DRAWINGS

The above and other objects, features and other advantages of the present invention will be more clearly understood from the following detailed description taken in conjunction with the accompanying drawings, in which:

FIG. 1 is a perspective view illustrating the longitudinal section of a central body of a conventional LED package;

FIG. 2 is a perspective view illustrating an LED package of the invention;

FIG. 3 is a side elevation view seen from an arrow A direction of FIG. 2; and

FIG. 4 is a plan view illustrating an LED package of the invention.

### DETAILED DESCRIPTION OF THE PREFERRED EMBODIMENT

Preferred embodiments of the present invention will now be described in detail with reference to the accompanying drawings.

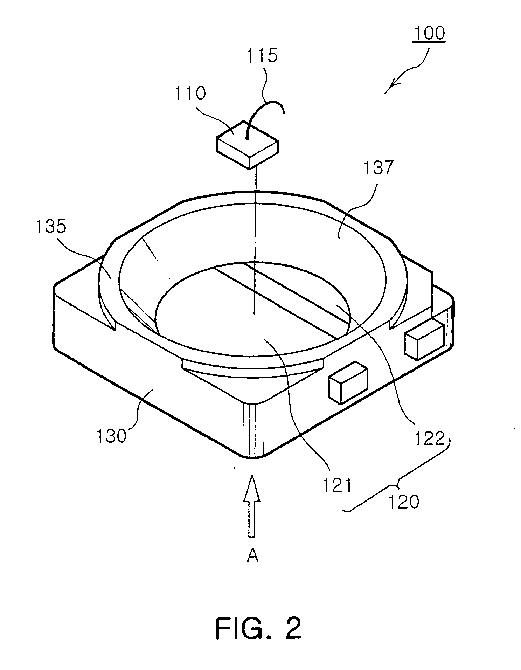

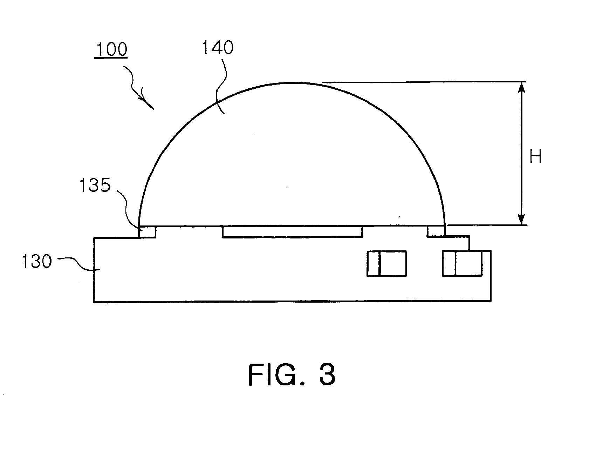

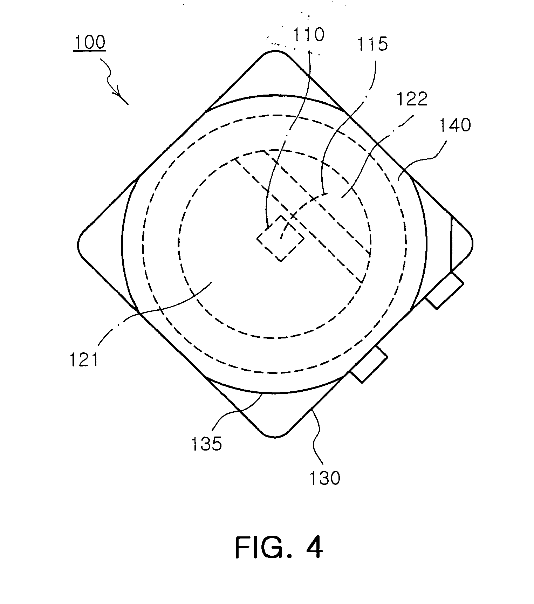

FIG. 2 is a perspective view illustrating an LED package according to the invention. FIG. 3 is a side elevation view seen from an arrow A direction of FIG. 2. FIG. 4 is a plan view illustrating an LED package according to the invention.

As shown in FIGs. 2 to 4, the LED package 100 of the invention does not require a complicated process for assembling a separately manufactured lens. But in a simpler manufacturing process, the LED package 100 of the invention has a resin filled to cover a light emission source in an upward dome shape. This serve to widen a view angle of the LED package 100. The LED package 100 of the invention includes a light emitting chip 110, a frame 120, a molding and a lens 140.

The light emitting chip 110 emits light when current is applied and generates heat when emitting light.

Such a light emitting chip is constructed of an active layer and a clad layer formed onto the sides of the active layer. A material for the light emitting chip includes but not limited to GaAlAs, and AlGaIn, AlGaInP, AlGaInPAs used for a red semiconductor laser device of a high density optical disc and GaN used in an electronic device such as a transistor. Of course, the light emitting chip may be variously configured with other semiconductor materials.

The frame 120 is fixed inside the molding 130 formed. The frame is constructed of a pair of first and second lead frames 121 and 122 which each has a portion of a top surface exposed through a cavity C of the molding 130. The first and second lead frames 121 and 122 are made of a conductive metal structure electrically connected to the light emitting chip 110.

Accordingly, the first and second lead frames 121 and 122 are made of one selected from a group consisting of copper, nickel, iron and alloys thereof. The first and second lead frames 121 and 122 each have an outer surface plated with a metallic material selected from a group consisting of nickel, silver, gold and alloys thereof.

Here, the light emitting chip 110 is configured as a vertical semiconductor device having p- and n-electrodes formed on opposed faces or as a planar semiconductor device having p- and n-electrodes formed on the same upper surface.

The vertical light emitting chip 110 is eutectic bonded and soldered to the first lead frame 121 by a metallic material. Alternatively, the vertical light emitting chip 110 is bonded to the first lead frame 121 by a conductive adhesive and electrically connected to the second lead frame 122 by a metallic wire 115.

On the other hand, the planar light emitting chip is mounted on the first lead frame 121 by an adhesive and electrically wire bonded to the first and second lead frames 121 and 122 via two metallic wires 115.

The molding 130 forms the cavity C in a central portion thereof, which surrounds the light emitting chip 110. The molding 130 is formed integral with the frame 120 and injection-molded to fix the frame 120. The first and second lead frames 121 and 122 of the frame 120 each have a top surface thereof exposed to the outside through a bottom surface of the cavity C. Meanwhile, the first and second lead frames 121 and 122 each have an underside surface thereof exposed through the bottom surface of the molding 130 to be electrically connected to an external power with ease.

The molding 130 may be variously configured and is formed of a polymer resin which is easily injection molded. But the invention is not limited thereto and various resins may be adopted.

Preferably, a reflecting member 137 is disposed on an inner surface of the cavity C which surrounds the light emitting chip 110. The reflecting member 137 reflects light generated from the light emitting chip 110 to further enhance light extraction efficiency.

This reflecting member 137 is formed by evenly coating or depositing a high reflectivity material selected from a group consisting of Al, Ag, Pt, Ti, Cr and Cu onto the entire slanted inner surface of the cavity C. But the invention is not limited thereto. Alternatively, the reflecting member 137 may be formed by attaching a plate made of a high light reflective material selected from Al, Ag, Pt, Ti, Cr and Cu.

In addition, the molding 130 has an embossed protrusion 135 protruded from a top surface thereof at a predetermined height H with respect to the light emitting chip 110. The embossed protrusion 135 is shaped as a circular ring. Further, the embossed protrusion 135 has an inner surface extending from the inner surface of the cavity C and an outer surface extending perpendicular to the top surface of the molding 130.

Here, preferably, the light emitting chip 110 disposed in the cavity C is aligned with the center of an inner diameter of the embossed protrusion 135.

The lens 140 is made of a transparent resin filled in the cavity C and cured into a dome shape. The lens 140 protects the light emitting chip 110 inside the cavity C from an external environment and ensures light generated from the light emitting chip 110 to be emitted outward in a wider view angle.

Preferably, the lens 140 is domed upward from the embossed protrusion 135 along an outer periphery of the embossed protrusion 135 of the molding 130.

The transparent resin is filled in the cavity C by a dispensing process for employing a separate dispenser or a stencil process. The transparent resin upon being filled up to an uppermost end of the embossed projection migrates to around a boundary between the horizontal top surface of the embossed projection 135 and a vertical outer surface thereof due to fluidity.

At this time, surface tension prevents the viscous transparent resin from flowing down to the top surface of the molding 130 along the perpendicular outer surface of the embossed protrusion 135.

The transparent resin, if continuously supplied in this state, forms the dome-shaped lens 140 which is gradually increased in a height H between the top surface of the embossed projection 135 and a maximum apex. With the lens 140 reaching a preset height, the transparent resin is no longer supplied.

The height of the lens 140 affects the light extraction efficiency and view angle. With increase in the height H of the lens 140 made of the transparent resin, the light extraction efficiency is elevated but the view angle is narrowed. On the other hand, with reduction in the height H of the lens 140 up to the embossed projection, the view angle is widened but the light the extraction efficiency is lowered.

To adopt the LED package for lighting, light radiated therefrom to the outside should have a view angle ranging from 120 degree to 180 degree. For a general flash, light should have a view angle of 80 to 120 degrees. Also, for a high-luminance flash, light should have a view angle of 80 degree or less.

Accordingly, the height H of the lens 149 is determined in consideration of a desired light extraction efficiency and view angle, which is varied according to the use of the LED package such as lighting and flash. The height H of the lens is adjusted by viscosity that affects flow of a resin and a thixotropic index that affects shape of the resin.

That is, with the resin viscosity maintained constant, the thixotropic index should be raised to increase the height of the lens 140. On the contrary, the thixotropic index should be lowered to decrease the height H of the lens 140.

Meanwhile, with the thixotropic index maintained constant, high viscosity of the resin requires a considerable amount of time to eliminate resin tail after dotting the transparent resin in order to form the dome-shaped lens 140. This accordingly degrades work productivity. In contrast, low viscosity of the resin may alter the dome shape, thus required to be cured quickly.

Moreover, the lens 140 domed upward from the embossed protrusion 135 is cured naturally or artificially to be integral with the molding 130.

This transparent resin is selectively made of silicon or epoxy. But silicone is most preferable due its less damage by a low wavelength light.

Meanwhile, preferably, the light transmissible resin of the dome-shaped lens 140 contains a light scattering agent designed to reduce noises of light radiated from the light emitting chip 110 and thus emit milder light.

The light transmissible resin is made of resin-based epoxy or silicone. Alternatively, the light transmissible resin is made of one selected from a group consisting of opal-based barium titanate, titanium oxide, aluminum oxide, and silicone oxide.

As set forth above, according to preferred embodiments of the invention, a light transmissible resin is filled in a cavity which surrounds a light emitting chip. A circular ring-shaped embossed protrusion is formed on a top surface of a molding to prevent the light transmissible resin from flowing down to a molding due to surface tension. This accordingly forms an upward dome on the top surface of the molding. Thus the invention obviates a need for assembling a separately manufactured lens in the molding and filling a filler between the lens and molding. In place thereof, the invention employs a transparent resin injected in the molding to form the circular ring-shaped dome. This simplifies an assembly process and enhances work productivity, thereby achieving mass production and saving manufacturing costs.

Moreover, the invention sufficiently widens a view angle of light generated from the light emitting chip and boosts light extraction efficiency, thereby enhancing optical efficiency.

In addition, according to the invention, viscosity and thixotropic index of the lens are adjustable to form various configurations of dome-shaped lenses, thereby elevating a degree of freedom in designing the lens.

While the present invention has been shown and described in connection with the preferred embodiments, it will be apparent to those skilled in the art that modifications and variations can be made without departing from the spirit and scope of the invention as defined by the appended claims.

## Claims

1. A light emitting diode package comprising:
a light emitting chip for generating light when current is applied;
a frame electrically connected to the light emitting chip via a wire, and having the light emitting chip mounted thereon;
a molding fixing the frame thereto, and having a cavity surrounding the light emitting chip and an embossed protrusion formed on a top surface thereof; and
a lens domed upward from the embossed protrusion along an outer periphery of the embossed protrusion, the lens comprising a light transmissible resin filled in the cavity.

2. The light emitting diode package according to claim 1, wherein the embossed protrusion is shaped as a circular ring, which has an inner surface extending from an inner surface of the cavity and an outer surface extending perpendicular to a top surface of the molding.

3. The light emitting diode package according to claim 2, wherein the light emitting diode disposed in the cavity is aligned with the center of an inner diameter of the embossed protrusion.

4. The light emitting diode package according to claim 1, further comprising a reflecting member for reflecting light generated from the light emitting chip disposed on an inner surface of the cavity.

5. The light emitting diode package according to claim 1, wherein the lens further comprises a light scattering agent contained in the light transmissible resin.

6. The light emitting diode package according to claim 5, wherein the light scattering agent comprises at least one of epoxy and silicone.

7. The light emitting diode package according to claim 5, wherein the light scattering agent comprises one selected from a group consisting of barium titanate, titanium oxide, aluminum oxide and silicone oxide.

8. The light emitting diode package according to claim 1, wherein a height of the lens is adjusted by viscosity that affects flow of a resin and a thixotropic index that affects shape of the resin.
